# EUROPEAN PATENT APPLICATION

(11) **EP 0 806 798 A2**
(43) Date of publication of application: **12.11.1997**
(21) Application number: 97303105.7
(22) Date of filing: 07.05.1997
(51) Int. Cl.: H01L 21/68

(54) **Substrate support chuck having a contaminant containment layer and method of fabricating same**

(30) Priority: 08.05.1996 US 639840
(71) Applicant: APPLIED MATERIALS, INC., Santa Clara, California 95054-3299 (US)
(72) Inventor: Harvey, Stefanie E., Santa Clara, California 95054 (US)
(74) Representative: Bayliss, Geoffrey Cyril

(57) **Abstract**

The disclosure relates to a workpiece support chuck (104) having a contaminant containment layer (100) deposited upon a support surface (102) thereof and a method of fabricating same. The containment layer is fabricated of an amorphous material. Such materials include borosilicates, fluorosilicates, doped ceramics, conductive oxide films, diamond films and the like. The containment layer (100) is formed upon the support surface using one of a variety of material deposition techniques including chemical vapor deposition (CVD), plasma enhanced CVD, sputtering, flame spraying, and the like.

## Description

The invention relates to a substrate support chuck for supporting a semiconductor wafer within a semiconductor processing system. More particularly, the invention relates to a contaminant container layer deposited upon the surface of a substrate support chuck for supporting a semiconductor wafer such that the surface of the wafer that faces the chuck does not contact the surface of the substrate support chuck.

Substrate support chucks are widely used to support substrates within semiconductor processing systems. A particular type of chuck used in high temperature semiconductor processing systems such as high temperature, physical vapor deposition (PVD) is a ceramic electrostatic chuck. These chucks are used to retain semiconductor wafers, or other work pieces, in a stationary position during processing. Such electrostatic chucks contain one or more electrodes embedded within a ceramic chuck body. The ceramic material is typically aluminum nitride or alumina doped with a metal oxide such as titanium oxide (TiO₂) or some other ceramic material with similar resistive properties. This form of ceramic is partially conductive at high temperatures.

In use, a wafer rests flush against the surface of the chuck body as a chucking voltage is applied to the electrodes. Because of the conductive nature of the ceramic material at high temperatures, the wafer is primarily retained against the ceramic support by the Johnsen-Rahbek effect. Such a chuck is disclosed in U.S. Patent 5,117,121, issued May 26, 1992.

One disadvantage of using a chuck body fabricated from a ceramic material is that during manufacture of the support, the ceramic material is "lapped" to produce a relatively smooth surface. Such lapping produces particles that adhere to and become trapped in pores on the surface of the chuck body. These particles are very difficult to completely remove from the surface. Consequently, it has been found that tens of thousands of contaminant particles may be found on the backside of a given wafer after retention upon a ceramic electrostatic chuck.

Additionally, the sintering process used to fabricate a ceramic chuck results in "grains" of ceramic material that can be easily "pulled outs" of the surface of the chuck. Furthermore, the lapping process may fracture the surface of the chuck body. Consequently, as the chuck is used, particles are continuously produced by these fractures. Also, during wafer processing, the ceramic material can abrade the wafer oxide from the underside of the wafer, resulting in further introduction of contaminants to the process environment. During use of the chuck, the particles and/or ceramic grains can adhere themselves to the underside of the wafer and be carried to other process chambers or cause defects in the circuitry fabricated upon the wafer.

Japanese Patent Application No. 60-261377, published December 24, 1985, discloses a ceramic electrostatic chuck having an embossed support surface. The embossing reduces the surface area of the ceramic support that contacts the wafer. Consequently, the number of contaminant particles transferred to the wafer is reduced. However, such an embossed pattern maintains some degree of contact between the ceramic material and the underside of the wafer. Also, the electrostatic force used to retain a workpiece upon the chuck charges the particles that lie within the embossed pattern. These particles are electrostatically attracted to the underside of the wafer and adhere thereto. Thus, contamination, though reduced, is still substantial.

Similarly, substrate support chucks that are used in low temperature processing (e.g., less than 300°C) may also produce contaminant particles that interfere with the wafer processing. Such low temperature chucks include electrostatic chucks and mechanical clamping chucks which contain wafer support surfaces that are typically fabricated from dielectric materials such as alumina. These types of chucks have also been found to produce particular contaminants during use that can adhere to the underside of the wafer during processing.

Therefore, a need exists in the art for apparatus that reduces the amount of contaminant particles that adhere to the underside of a wafer while supported upon a chuck.

The disadvantages associated with the prior art are overcome by the present invention of a coating deposited upon the surface of a chuck. More specifically, the invention is a contaminant containment layer having a thickness of approximately 5 to 10 microns deposited upon the support surface of the chuck. To produce a partially conductive surface that facilitates the Johnsen-Rahbek effect, the containment layer is fabricated from a doped amorphous material that has superior contact properties as compared to the chuck surface material, including being less abrasive and generally more compliant. Illustrative containment layer materials include borosilicates, flourosilicates, doped alumina, polysilicon films, conductive oxide films, diamond coatings and the like.

The containment layer seals the contaminant particles and grains that lie on the surface of the chuck to the chuck surface. As such, the wafer is supported by the containment layer and not directly by the support surface of the chuck. Consequently, the spaced apart relationship of the wafer relative to the chuck surface ensures that the contaminants on the chuck surface can not adhere to the underside of the wafer. In this manner, contamination of the wafer and the process chamber are substantially reduced.

The teachings of the present invention can be readily understood by considering the following detailed description in conjunction with the accompanying drawings, in which:
FIG. 1 depicts a vertical cross-section view of a ceramic electrostatic chuck containing the contaminant containment layer of the present invention; and
FIG. 2 depicts a top plan view of the ceramic electrostatic chuck of FIG. 1.

To facilitate understanding, identical reference numerals have been used, where possible, to designate identical elements that are common to the figures.

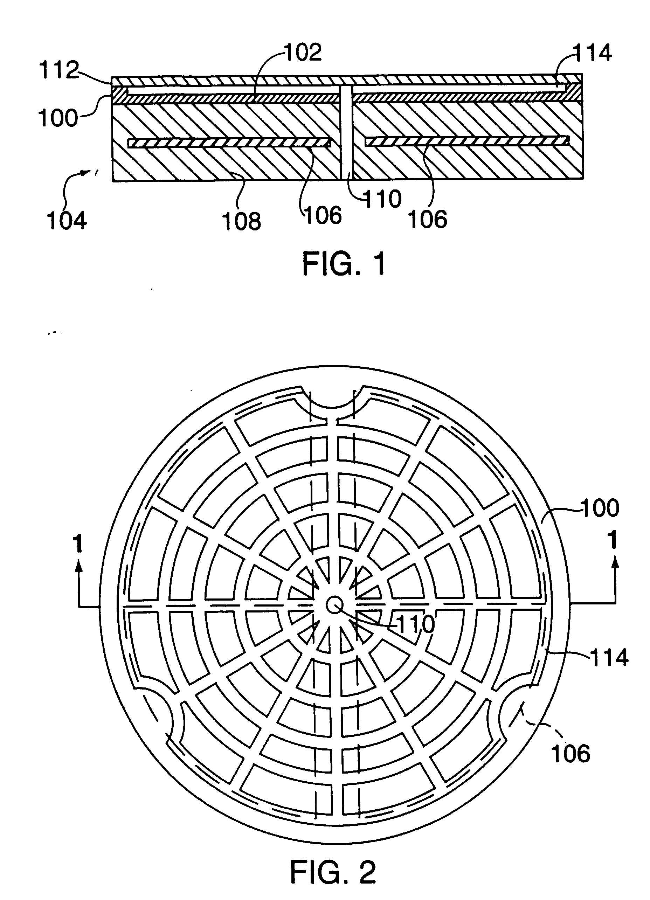

FIG. 1 depicts a vertical cross-sectional view of a contaminant containment layer 100 deposited atop the support surface 102 of a ceramic electrostatic chuck 104. To illustrate the use of the invention, FIG. 1 depicts the containment layer 100 supporting a semiconductor wafer 112. FIG. 2 depicts a top plan view of the layer 100 of FIG. 1 (without the wafer 112). For best understanding of the invention, the reader should refer to both FIGS. 1 and 2 while reading the following disclosure.

Although the preferred embodiment of the present invention is discussed as used in conjunction with a ceramic electrostatic chuck, the invention is also useful in supporting substrates above any form of chuck, including non-ceramic electrostatic chucks, mechanical clamping chucks, and the like. One important feature of the invention is that the containment layer be fabricated from a material that has contact properties that are different from the chuck materials such that the material of the surface does not contact the underside of the wafer. Consequently, the surface of the chuck is, in essence, sealed from the process chamber environment.

In the preferred embodiment, the electrostatic chuck 104 contains one or more electrodes 106 embedded within a ceramic chuck body 108. Although a bipolar pair of electrodes is depicted, the electrodes may be monopolar or bipolar. Additionally, electrodes may have various shapes including circular, D-shape, interdigitated and the like. The ceramic chuck body is, for example, fabricated of aluminum nitride or boron nitride. Such a partially conductive ceramic material promotes the Johnsen-Rahbek effect during high-temperature processing of a semiconductor wafer. Other partially conductive ceramics also form useful high temperature chuck materials such as alumina doped with titanium oxide or chromium oxide. If the chuck is to be used at low temperatures only, then other ceramic and/or dielectric materials such as alumina are used to form the chuck body. An illustrative ceramic electrostatic chuck is disclosed in commonly assigned U.S. Patent Application Serial Number 08/073,028 filed June 7, 1993, herein incorporated by reference. Examples of non-ceramic electrostatic chucks are disclosed in U.S. Patent 4,184,188 issued January 15, 1980 and U.S. Patent 4,384,918 issued May 24, 1983, both of which are incorporated herein by reference.

The containment layer 100 is deposited upon the support surface 102 of the chuck body 108 typically using a chemical vapor deposition (CVD) process. Other deposition techniques include sputtering, plasma enhanced CVD, flame spraying and the like. The material of the containment layer has a superior contact property as compared to the surface material of the chuck. For example, the coating material is generally less abrasive and more compliant (e.g., produces less particles) than the surface material of the chuck. Typically, the material used to form the containment layer upon a ceramic chuck is amorphous in structure such as a doped glass-like material. Such materials include borosilicates, flourosilicates, and the like. Other materials that can be used as layer 100 include conductive oxide films, polysilicon films and a thinly (approximately 5 µm thick) deposited layer of partially conductive ceramic, e.g., aluminum nitride, boron nitride, and the like. Such thinly deposited ceramics do not require lapping nor sintering and, as such, are not fractured or porous. Consequently, a thinly deposited layer of the same material as used in the chuck body does not produce nor retain contaminant particles like the lapped surface of the chuck body.

In addition, a diamond coating of less than 5 µm thick can also be used to form the containment layer. Such a thin layer does not substantially interfere with the Johnsen-Rahbek effect that retains the wafer upon the chuck. Such a thin diamond coating is formed using deposition techniques such as hot filament deposition CVD, or plasma enhanced CVD among others.

In short, whatever the material, the containment layer material is deposited to a pre-defined thickness of approximately 5 to 10 micrometers. The layer is evenly and conformally deposited across the entire surface of the electrostatic chuck.

To facilitate heat transfer from the wafer to the chuck body, a heat transfer medium, e.g., a gas such as helium, is pumped into the space into the interstitial spaces between the backside surface of the wafer 112 and the upper surface of the containment layer. This cooling technique is known as "backside cooling." The heat transfer medium is provided to the backside of the wafer via a port 110 that is formed through the chuck body and the containment layer. The medium is typically supplied to the underside of the wafer at a rate of 2 to 30 sccm. Such backside cooling is well known in the art and is disclosed, for example, in commonly assigned U.S. Patent 5,228,501 issued to Tepman, et al., on July 20, 1993. Additional heat transfer medium distribution channels 114 may be formed in the surface of the glass layer to aid distribution of the heat transfer medium across the underside of the wafer.

The channels are typically cut into the surface of the chuck and the containment layer conformally coats the chuck surface to produce the channels in the containment layer. However, the channels could be formed using a mask during containment layer deposition or could be cut into the hardeped containment layer material.

Using the contaminant containment layer of the present invention in conjunction with a ceramic chuck results in a substantial decrease in particulate contamination of wafers and the process chamber environment. Importantly, the containment layer does not significantly interfere with the clamping process or impact the clamping force that retains the wafer upon the electrostatic chuck.

Although various embodiments which incorporate the teachings of the present invention have been shown and described in detail herein, those skilled in the art can readily devise many other varied embodiments that still incorporate these teachings.

## Claims

1. Apparatus for supporting a workpiece comprising:
a contaminant containment layer, deposited upon a support surface of a workpiece support chuck, for supporting said workpiece in a spaced-apart relation to said support surface.

2. The apparatus of claim 1 wherein said contaminant containment layer is a doped glass.

3. The apparatus of claim 2 wherein said doped glass is a borosilicate.

4. The apparatus of claim 2 wherein said doped glass is a flourosilicate.

5. The apparatus of claim 1 wherein said support surface is fabricated of a ceramic material.

6. The apparatus of claim 5 wherein said ceramic material is partially conductive at temperatures above approximately 300°C.

7. The apparatus of claim 6 wherein said ceramic material is aluminum nitride, boron nitride, or alumina doped with a conductive oxide.

8. The apparatus of claim 1 wherein said support surface is fabricated of a dielectric material.

9. Apparatus for supporting a workpiece comprising:
a ceramic electrostatic chuck having a plurality of electrodes embedded beneath a support surface;
a layer, deposited upon said support surface of said ceramic electrostatic chuck for supporting a workpiece proximate said ceramic electrostatic chuck, where said coating is fabricated of a doped glass.

10. The apparatus of claim 9 wherein a support surface of said electrostatic chuck is fabricated of aluminum nitride, boron nitride, or alumina doped with a conductive oxide.

11. The apparatus of claim 9 wherein said doped glass is a borosilicate.

12. The apparatus of claim 9 wherein said doped glass is a flourosilicate.

13. A method of fabricating a workpiece support chuck comprising the steps of:
providing a workpiece support chuck having a support member;
depositing an amorphous material as a uniform layer over a support surface of said support member to form a contaminant containment layer.

14. The method of claim 13 wherein said depositing step comprises the step of using a chemical vapor deposition process to deposit the amorphous material.

15. The method of claim 13 wherein said amorphous material is a borosilicate.

16. The method of claim 13 wherein said support member is fabricated of a ceramic material.

17. The method of claim 16 wherein said ceramic material is partially conductive at temperatures above approximately 300°C.

18. The method of claim 16 wherein said ceramic material is aluminum nitride, boron nitride, or aluminum doped with a conductive oxide.
